# EUROPÄISCHE PATENTANMELDUNG

(11) **EP 2 682 981 A2**
(43) Veröffentlichungstag der Anmeldung: **08.01.2014**
(21) Anmeldenummer: 13170752.3
(22) Anmeldetag: 06.06.2013
(51) Int. Cl.: H01L 21/67

(54) **Ausstoßvorrichtung zum Abheben eines Chips von einem Trägermaterial**

(30) Priorität: 04.07.2012 DE 102012013370
(71) Anmelder: Fraunhofer-Gesellschaft zur Förderung der angewandten Forschung e.V., 80686 München (DE)
(72) Erfinder: Rießle, Markus, 79211 Denzlingen (DE)

(57) **Zusammenfassung**

Die Erfindung betrifft eine Ausstoßvorrichtung und ein Verfahren zum Abheben eines Chips (2) von einem Trägermaterial (1) mit mindestens einer Nadel (4), wobei die Nadel (4) mindestens eine Schneide (7) aufweist zum Durchschneiden des Trägermaterials (1). Weiterhin betrifft die Erfindung eine Montagevorrichtung zum Einbringen und Fixieren mindestens einer Nadel (4) in eine Ausstoßvorrichtung zum Abheben eines Chips von einem Trägermaterial, mit einer Platte zum Ausrichten der Nadelspitzenebene und einer abnehmbaren Vorrichtung, die eine Ausnehmung aufweist, wobei die abnehmbare Vorrichtung derart an der Ausstoßvorrichtung anbringar ist, dass die Ausnehmung zum Einbringen des Fixiermaterials an die Nadelenden dient. Dabei wird ein Verfahren zum Fixieren der Nadeln in einer Ausstoßvorrichtung angewendet, wobei die mindestens eine Nadel zum Fixieren in der Ausstoßvorrichtung eingeschmolzen wird.

## Beschreibung

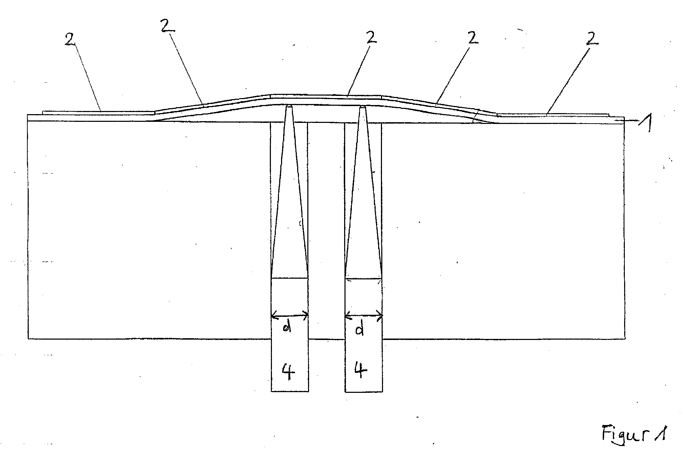

Die vorliegende Erfindung betrifft das Gebiet der Handhabung von elektronischen Bauelementen, welche üblicherweise auf einem Wafer prozessiert werden. Nach der Fertigstellung der einzelnen Bauelemente auf dem Wafer werden die Bauelemente vereinzelt. Dazu wird der Wafer auf einem Trägermaterial aufgebracht. Die zu vereinzelnden Bauelemente bzw. Chips werden auf dem Trägermaterial gesägt, ohne dass das Trägermaterial mit durchgesägt wird. Nach dem Sägen liegen die einzelnen Bauelemente durch Sägegräben voneinander getrennt auf dem Trägermaterial. Zur weiteren Verarbeitung müssen die Bauelemente von dem Trägermaterial abgehoben werden. Für dieses Abheben der einzelnen Bauelemente bzw. Chips von dem Trägermaterial werden in der Halbleiterindustrie spezielle Werkzeuge eingesetzt. Diese Ausstoßwerkzeuge heben die Chips mit Nadeln von der Rückseite des Trägers her ab. Ein solches Werkzeug nach dem Stand der Technik zeigt Figur 1. Hier wird mit an der Spitze abgerundeten Nadeln der Chip von der Seite her angehoben, die auf dem Trägermaterial angebracht ist. Das Trägermaterial ist üblicherweise eine adhäsive Trägerfolie. Dabei löst sich durch das gemeinsame Anheben von Trägermaterial und Chip die Haftung des Trägermaterials am Rand des Chips. Es bleibt eine Resthaftung zwischen Trägermaterial und Chip. Der Chip wird nun zur weiteren Bearbeitung mit einem Vakuumgreifer, abgenommen. Das Trägermaterial wird bei diesem Vorgang vom Ausstoßwerkzeug üblicherweise nicht durchtrennt.

Die EP 0 565 781 B1 zeigt ebenfalls ein Ausstoßwerkzeug der Halbleiterindustrie. Hier wird mithilfe einer Ausstossernadel, die ortsfest angeordnet ist, der Chip durch den adhäsive Trägerfolie hindurch angehoben. Die Trägerfolie wird bei diesem Vorgang nicht unbedingt von der kegelförmigen Nadel durchstochen. Wird sie durchstochen, so entsteht nur ein kleines Loch, so dass beim weiteren Hochfahren der Nadel bedingt durch die konische, kegelförmige Form der Nadel die Trägerfolie weiter mitangehoben wird.

Das Problem beim Vorgang des Abhebens der vereinzelten Chips aus dem Waferverbund ist, dass dabei die Gefahr besteht, dass der Chip zu Bruch geht bzw. die angrenzenden Chips beschädigt werden. Nachteil des Standes der Technik ist dabei, dass entweder Restadhäsionskräfte der adhäsiven Trägerfolie auf den Chip wirken, während dieser mit dem Aufnahmewerkzeug, üblicherweise ein Vakuumgreifer, vom Austoßwerkzeug abgenommen wird, oder dass bereits beim Anheben des Chips mit der Nadel des Ausstoßwerkzeugs zu viel Druck und Spannung auf das Trägermaterial durch das Mitanheben des Trägermaterials durch die Nadel und damit auch auf den abzuhebenden Chip und auf die angrenzenden Chips ausgeübt wird und dabei die Chips zu Bruch gehen. Aufgabe der Erfindung ist es daher, die Chipbruchgefahr zu vermindern und damit die Ausbeute an funktionierenden Chips zu erhöhen. Insbesondere für Chips, die stark gedünnt sind, die aus einem besonders brüchigem Material sind oder die keine einfache rechteckige Form aufweisen, weil sie z.B. Hohlleiterantennen monolithisch mit integriert haben, soll ein Verfahren und eine Vorrichtung zur Verfügung gestellt werden, die auch hier ein beschädigungsfreies Abheben der Chips ermöglichen bzw. die Ausbeute an unbeschädigten Chips erhöhen.

Die Aufgabe wird insbesondere gelöst durch die Gegenstände der unabhängigen Patentansprüche. Vorteilhafte Ausführungsformen der vorliegenden Erfindung sind in den abhängigen Ansprüchen beschrieben.

Vorgesehen ist eine Ausstoßvorrichtung zum Abheben eines Chips von einem Trägermaterial mit mindestens einer Nadel, wobei die Nadel mindestens eine Schneide aufweist. Die Schneide hat den Vorteil, dass während des Abhebens des Chips von der Seite her, auf der das Trägermaterial sich befindet, das Trägermaterial während des Anhebens des Chips von der mindestens einen Nadel durchschnitten wird. Dies verhindert, dass das Trägermaterial beim Abhebevorgang mit angehoben wird und dadurch Druck auf die benachbarten Chips ausgeübt wird. Zum Abheben des Chips wird die Nadel gegen das Trägermaterial und den darauf liegenden Chip gedrückt. Dabei wird das Trägermaterial nur zu Beginn leicht angehoben bis die Spitze der Nadel das Trägermaterial leicht durchsticht, beim weiteren Hochfahren der Nadel wird aufgrund der Schneide entlang des vorderen Teils der Nadel das Trägermaterial durchschnitten und dadurch nicht weiter angehoben.

Durch die Schneide wird der Eindringwiderstand der Nadel verringert, das Trägermaterial wird durch den Druck der Nadelschneide gegen das Trägermaterial beim Abhebevorgang durchschnitten. Damit sind die mechanischen Kräfte, die auf die Chips während des Abhebevorgangs einwirken, erheblich verringert. Außerdem wirken keine Restadhäsionskräfte des Trägermaterials auf den Chip, wenn dieser nach dem Abheben mit einem Vakuumgreifer von dem Ausstoßwerkzeug abgenommen wird zur weiteren Bearbeitung.

Unter einer Nadel wird hier eine stabförmige Vorrichtung gesehen, wobei der vordere Teil der Nadel derjenige ist, der am Abhebevorgang beteiligt ist. Das vorderste Ende der Nadel wird als Nadelspitze bezeichnet. Die Nadelspitze tritt beim Abhebevorgang als erstes mit dem Trägermaterial und mit dem Chip in Kontakt und trägt den Chip beim Abhebevorgang.

Als Nadelende wird das der Nadelspitze gegenüberliegende Ende der Nadel bezeichnet.

Als vorteilhaft wurde hier erkannt, dass der Schliff des vorderen Teils der Nadel mindestens eine Schneide aufweist, die das Trägermaterial während des Abhebevorgangs durchschneidet. Die Nadel wird so geschärft, dass eine scharfe Kante entsteht, die das Trägermaterial durchschneidet, also durchtrennt. Bevorzugt ist die Schneide als Seitenkante entlang des vorderen Teils der Nadel ausgebildet. Dabei kann der vordere Teil der Nadel messerförmig ausgebildet sein, mit einer scharfen Seitenkante oder auch zwei sich gegenüberliegenden scharfen Seitenkanten. Die Schneide ist als Seitenkante keilförmig geschliffen. Bevorzugt werden die Schneiden so präpariert, dass die Nadel zusätzlich zur Nadelspitze hin allmählich dünner wird.

Erfindungsgemäß wird also eine Nadel zum Abheben eines Chips von einem Trägermaterial verwendet, die mindestens eine Schneide aufweist zum Durchschneiden des Trägermaterials.

Als Trägermaterial wird hier bevorzugt eine adhäsive Trägerfolie verwendet, auf der der Wafer zum Vereinzeln der Chips aufgebracht wird und an dieser haften bleibt. Dies kann z. B. eine Kunststofffolie sein.

Der abzuhebende Chip ist z. B. ein Halbleiter-Chip, der auf einem Halbleiter-Wafer gefertigt wurde. Insbesondere für MMICs, aus III/V-Halbleitermaterial gefertigte Chips, also z.B. aus GaAs oder InP gefertigte Chips, die auf 20 bis 100 µm gedünnt sind, ist die erfindungsgemäße Ausführungsform der Ausstoßvorrichtung und das erfindungsgemäße Verfahren von Vorteil.

Eine weitere Ausführungsform der Ausstoßvorrichtung zum Abheben eines Chips von einem Trägermaterial weist mindestens eine Nadel auf, wobei der Durchmesser der Nadel kleiner oder gleich 0,25 mm ist. Diese Wahl des Durchmessers der Nadel bewirkt, dass der Eindringwiderstand der Nadel in das Trägermaterial während des Abhebevorgangs gering ist. Ausgehend von diesem Durchmesser kann die Nadel zusätzlich mit einem Schliff am vorderen Teil der Nadel versehen sein. Insbesondere kann die Nadel zusätzlich mit mindestens einer Schneide versehen sein.

In einer weiteren Ausführungsform ist die Nadel der Ausstoßvorrichtung mit drei Schneiden zum Durchschneiden des Trägermaterials versehen. Durch den Einsatz von drei Schneiden wird das Trägermaterial von der Nadel während des Abhebens des Chips durchschnitten, also durchtrennt. Bevorzugt werden die Schneiden so präpariert, dass die Nadel zusätzlich zur Nadelspitze hin allmählich dünner wird.

Es wird hier also eine Nadel zum Abheben eines Chips von einem Trägermaterial verwendet, die drei Schneiden aufweist zum Durchschneiden des Trägermaterials.

Die Schneiden sind entlang des vorderen Teils der Nadel so ausgebildet, dass drei scharfe Seitenkanten z. B. pyramidenförmig entlang des vorderen Teils der Nadel führen. Diese durchschneiden das Trägermaterial entlang des Anhebeweges beim Hochfahren der Nadel. Dadurch wird der Chip vom Trägermaterial und aus dem Chipverbund gelöst.

In einer weiteren Ausführungsform weist die Ausstoßvorrichtung einen Nadelhalter auf mit Bohrungen zum Aufnehmen mindestens einer Nadel, des Weiteren weist die Ausstoßvorrichtung einen Nadelkopf auf und eine Druckfeder, wobei der Nadelkopf und der Nadelhalter derart zusammenfügbar sind, dass über die Druckfeder Nadelkopf und Nadelhalter im zusammengefügten Zustand relativ zueinander bewegbar sind. Dies hat den Vorteil, dass die Ausstoßvorrichtung im Betrieb so arbeitet, dass die Nadelspitzen sich versenkt in der Ausstoßvorrichtung befinden, damit die Spitzen geschützt werden. Das Trägermaterial mit dem Wafer fährt im Betrieb über den Nadelkopf und kann die versenkten Spitzen nicht beschädigen. Erst wenn der auszustoßende Chip über dem Nadelkopf platziert ist, werden die Nadeln in Richtung Nadelkopf gedrückt und die Nadelspitzen treten in Kontakt mit dem darüber liegenden Trägermaterial und dem darauf aufgebrachten Chip.

Als Druckfeder werden Bauteile bezeichnet, die unter Belastung nachgeben und nach Entlastung in die ursprüngliche Gestalt zurückgehen, sich also elastisch rückstellend verhalten.

Als weitere Ausführungsform der Ausstoßvorrichtung ist die Ausstoßvorrichtung in Abhängigkeit der Chipfläche des abzuhebenden Chips mit Nadeln bestückbar, wobei die Nadeldichte mindestens drei Nadeln pro 1 mm² Chipfläche beträgt. Die Nadeldichte der Ausstoßvorrichtung wird also in diesem Ausführungsbeispiel so gewählt, dass auf 0,33 mm² Chipfläche mindestens eine Nadel ansetzt. Dies hat den Vorteil, dass das Problem der konzentrierten Krafteinwirkung auf den Chip während des Abhebevorgangs auf mehrere Nadeln verteilt wird. Diese Druckverteilung verringert das Biegemoment auf den Chip, da gleichzeitig an mehreren Stellen auf den Chip eingewirkt wird. Dies führt dazu, dass der Chip beim Abhebevorgang weniger leicht bricht. Da erfindungsgemäß in einer bevorzugten Ausführungsform der Durchmesser der verwendeten Nadeln besonders klein gewählt wird, kann hier die Nadeldichte pro Chipfläche im Gegensatz zum Stand der Technik, der mit Nadeldurchmessern von 0,5 bis 0,7 mm arbeitet, erhöht werden. Weitere Nadeldichten, die erfindungsgemäß eingesetzt werden, sind vorzugsweise 4 Nadeln pro 1 mm² Chipfläche, also auf 0,25 mm² mindestens eine Nadel ansetzt, sowie mindestens 5 Nadeln pro 1 mm² Chipfläche, also mindestens 1 Nadel auf 0,2 mm² Chipfläche ansetzt. Die erfindungsgemäß gewählte Nadeldichte liegt also vorzugsweise mindestens bei 3 bis 5 Nadeln pro 1 mm² Chipfläche.

In einer weiteren Ausführungsform ist die mindestens eine Nadel im Nadelhalter derart fixiert, dass die mindestens eine Nadel mittels Schmelzklebstoff im Nadelhalter fixiert ist. Damit ist die Nadel in einem erstarrten Medium im Nadelhalter fixiert. Dies bedeutet, dass die mindestens eine Nadel bei der Herstellung der Ausstoßvorrichtung in ein flüssiges Medium im Nadelhalter eingebracht wird, bzw. das flüssige Medium auf die Nadel im Nadelhalter aufgebracht wird, und im nachfolgenden Prozess während das Medium erstarrt oder aushärtet, eine Fixierung der Nadeln im Nadelhalter erfolgt. Der Vorteil dieser Fixierung ist, dass bei der Fixierung der Nadel in der Ausstoßvorrichtung keine mechanischen Kräfte auf die Nadel einwirken, die eine Verformung der Nadel bewirken, wie es im Stand der Technik der Fall ist. Dort wird die Nadel über eine Madenschraube fixiert, was zu einem Verbiegen oder Verschieben der Nadeln führen kann.

Besonders geeignet als Medium zum Fixieren der Nadel ist ein Schmelzklebstoff, der durch Änderung der Temperatur von einem festen in einen flüssigen Zustand übergeht bzw. umgekehrt von einem flüssigen in einen festen Zustand übergeht. Bei Raumtemperatur ist er fest. Er wird in geschmolzener Form aufgetragen und haftet dann an der jeweiligen Oberfläche, wenn er wieder auf eine Temperatur unterhalb des Schmelzpunktes abgekühlt wird.

Das Verfahren zum Fixieren der Nadeln in einer Ausstoßvorrichtung zum Abheben eines Chips von einem Trägermaterial sieht die folgenden Schritte vor:
- Einbringen der mindestens einen Nadel in einen Nadelhalter der Ausstoßvorrichtung
- Fixieren der Nadeln, wobei die Nadelenden der Nadeln im Nadelhalter mittels eines Klebstoffs durch Erstarren oder Aushärten des Klebstoffs im Nadelhalter fixiert werden.

Das Verfahren hat den Vorteil, dass die Nadeln in der Ausstoßvorrichtung derart angebracht werden, dass möglichst kein Verspannen oder Verziehen der Nadeln erfolgt. Dies ist besonders dann wichtig, wenn mehrere Nadeln eingesetzt werden sollen, um z.B. eine größere Chipfläche abzudecken und dazu die Nadelspitzen möglichst exakt auf einer Ebene ausgerichtet sein sollen.

Klebstoffe sind nichtmetallische Werkstoffe, welche Substrate durch Adhäsion oder Kohäsion verbinden. Als besonders geeignet zum Fixieren der Nadeln haben sich Schmelzklebstoffe herausgestellt, insbesondere da diese leicht wieder ablösbar sind. Besonders geeignet ist ein Schmelzklebstoff, der durch ein Lösungsmittel wieder ablösbar ist. Ein Schmelzklebstoff wird in geschmolzener Form aufgetragen und haftet dann an der jeweiligen Oberfläche, wenn er wieder auf eine Temperatur unterhalb des Schmelzpunktes abgekühlt wird. Insbesondere geeignet sind wachshaltige Schmelzklebstoffe oder Schmelzklebstoffe, die aus Wachs bestehen.

Das Verfahren zum Fixieren von mindestens einer Nadel in einem Nadelhalter (8) einer Ausstoßvorrichtung zum Abheben eines Chips von einem Trägermaterial weist desweiteren vor dem Fixieren der Nadeln folgende Schritte auf,
- Einbringen der mindestens eine Nadel in mindestens eine Bohrung des Nadelhalters, wobei jeweils eine Nadel in jeweils eine Bohrung des Nadelhalters eingebracht wird
- Ausrichten der Nadelspitzenebene, wobei die lose in den Bohrungen der Ausstoßvorrichtung geführten Nadeln mit ihren Nadelspitzen auf einer ebenen Platte durch ihr Eigengewicht ausgerichtet werden.

Durch diese Verfahrensschritte wird sichergestellt, dass die Nadeln vor dem Fixieren in der richtigen Position sitzen und die Nadelspitzenebene eingestellt wird.

In einer weiteren Ausführungsform des Verfahrens ist der Klebstoff ein Schmelzklebstoff, wobei dieser in Form eines Granulats an die Nadelenden gebracht wird, und in einem weiteren Schritt wird das Granulat aufgeschmolzen und in einem weiteren Schritt erstarrt.

Durch das hier beanspruchte Verfahren wird sichergestellt, dass die Nadeln so am Werkzeug fixiert werden, dass sie bei der Fixierung nicht dejustiert werden.

In einer weiteren Ausführungsform des Verfahrens zum Fixieren von mindestens einer Nadel in einem Nadelhalter einer Ausstoßvorrichtung zum Abheben eines Chips von einem Trägermaterial wird noch ein weiterer Verfahrensschritt durchgeführt. Dabei wird nach dem Aufbringen des Klebstoffs noch vor dem Erstarren des Klebstoffs der Nadelhalter eine kurze Distanz, beispielsweise in etwa 0,5 mm, nach unten bewegt in Richtung der ebenen Platte, auf der die Nadelspitzen ausgerichtet sind, um so vor dem Erstarren des Klebstoffs noch einmal ein Ausrichten der Nadelspitzen in einer Ebene sicher zu stellen. Diese Bewegung des Nadelhalters in Richtung der ebenen Platte korrigiert, dass eventuell die eine oder andere Nadel durch das Verteilen des Klebstoffs leicht nach oben gezogen wurde und drückt wieder alle Nadelspitzen in Richtung der ebenen Platte.

Zum Durchführen der Montage der Ausstoßvorrichtung wird eine Montagevorrichtung verwendet. Die erfindungsgemäße Montagevorrichtung zum Einbringen und Fixieren mindestens einer Nadel in eine Ausstoßvorrichtung weist eine Platte zum Ausrichten der Nadelspitzenebene und eine abnehmbare Vorrichtung und ein Verbindungsstück auf, wobei die Platte (12) über das Verbindungsstück (14) mit der abnehmbaren Vorrichtung (13) verbindbar ist, derart, dass die abnehmbare Vorrichtung (13) so an Nadelhalter, Nadelkopf und Druckfeder über das Verbindungsstück (14) anbringbar ist, dass die Nadeln (4) nach dem Fixierungsvorgang versenkt in der Ausstoßvorrichtung angebracht sind. Vorteil dieses Merkmals ist, dass nach der Montage der Nadeln sich die Nadeln etwas versenkt im Ausstoßwerkzeug befinden und die Nadelspitzen dadurch geschützt sind. Nur im Einsatz des Ausstoßwerkzeuges werden zum Abheben des Chips die Nadeln aus dem Ausstoßwerkzeug gedrückt.

Gemäß einer weiteren Ausführungsform der Montagevorrichtung weist die abnehmbare Vorrichtung eine Ausnehmung auf, und die abnehmbare Vorrichtung ist mit der Ausnehmung derart über dem Nadelhalter der Ausstoßvorrichtung anbringbar, dass die Ausnehmung zum Einbringen des Fixiermaterials auf die Nadelenden im Nadelhalter dient.

Ein erfindungsgemäßes Verfahren zum Abheben eines Chips von einem auf einem Trägermaterial aufgebrachten Chipverbundes weist folgende Schritte auf: -Abheben des Chips mittels mindestens einer Nadel, wobei das Abheben des Chips von der dem Trägermaterial zugewandten Seite des Chips her erfolgt, wobei das Abheben derart erfolgt, dass die mindestens eine Nadel mindestens eine Schneide aufweist und die mindestens eine Nadel durch das Trägermaterial hindurch den Chip abhebt und beim Abheben das Trägermaterial durch die Schneide durchschnitten wird.

Eine weitere Ausführungsform eines Verfahrens zum Abheben eines Chips von einem Trägermaterial sieht vor, dass die mindestens eine Nadel einen Durchmesser kleiner oder gleich 0,25 mm aufweist. Dies hat den Vorteil, dass die Nadel beim Anheben das Trägermaterial durchtrennt. Insbesondere wenn die Nadel am vorderen Ende mit einer Schneide versehen ist, wird gewährleistet, dass die Trägerfolie, auf der die Chips aufliegen, während des Abhebevorgangs nicht bzw. kaum angehoben wird. Ein weiterer Vorteil ist, dadurch dass kaum Dehnungsspannungen auf die Folie wirken, die benachbarten Chips, die momentan nicht direkt am Abhebevorgang beteiligt sind, nicht beschädigt werden, was normalerweise, wenn die Trägerfolie beim Abhebevorgang angehoben wird, durch ein Verschieben der Chips stattfindet. Durch ein Anheben der Trägerfolie würden die benachbarten Chips mit ihren Kanten aufeinander rutschen und würden dadurch beschädigt. Dies wird durch die vorliegende Erfindung verhindert. Außerdem wirken keine Restadhäsionskräfte der Trägerfolie auf den Chip, wenn dieser zur weiteren Bearbeitung von der der Nadel gegenüberliegenden Seite mit einem Vakuumgreifer abgehoben wird.

Gemäß einer weiteren Ausführungsform des Verfahrens zum Abheben eines Chips von einem Trägermaterial werden folgende Schritte durchgeführt: -Abheben des Chips mit einer Ausstoßvorrichtung mit mindestens einer Nadel, wobei das Abheben des Chips von der dem Trägermaterial zugewandten Seite des Chips her erfolgt, wobei die mindestens eine Nadel durch das Trägermaterial hindurch den Chip abhebt **dadurch gekennzeichnet, dass** die Ausstoßvorrichtung in Abhängigkeit von der Fläche des abzuhebenden Chips mit Nadeln bestückt ist, und zwar mit einer Nadeldichte von mindestens einer Nadel pro 0,33 mm² Chipfläche.

Dies gewährleistet, dass pro Chipfläche genügend Nadelspitzen ansetzen, um die mechanischen Kräfte gleichmäßig über die Chipfläche zu verteilen, und nicht lokal einen zu großen Druck an einer Stelle des Chips aufbauen. Dabei hat sich herausgestellt, dass pro 1 mm² Chipfläche eine Verteilung von mindestens drei, mindestens vier oder mindestens fünf Nadeln über diese Chipfläche eine optimale Druckverteilung gewährleistet.

Insbesondere ist eine erfindungsgemäße Ausstoßvorrichtung geeignet für Fertigungsautomaten, die zum Abheben eines Chips von einem Trägermaterial und Aufnehmen des Chips zur Weiterverarbeitung eingesetzt werden, wobei mit einer erfindungsgemäßen Ausstoßvorrichtung der Chip vom Trägermaterial abgehoben wird, und mit einem Aufnahmewerkzeug wird der Chip von der Ausstoßvorrichtung abgenommen. Die Ausstoßvorrichtung gewährleistet, dass ein Chip aus einem Chipverbund, der auf einem Trägermaterial haftet, gelöst wird und so präsentiert wird, dass ein Aufnahmewerkzeug ihn aufnehmen kann ohne den Chip selbst oder die benachbarten Chips zu beschädigen. Solche Fertigungsautomaten in der Halbleiterindustrie legen den Chip dann z. B. in einer Verpackung ab. Solche Halbleiter-Fertigungsautomaten mit einer Ausstoßvorrichtung und einer Aufnahmevorrichtung sind z. B. Die-Bonder. Das Aufnahmewerkzeug ist üblicherweise ein Vakuumgreifer, der von der der Nadel der Ausstoßvorrichtung gegenüberliegenden Seite den Chip von der Nadel abnimmt. Dabei ist es von Vorteil bei diesem hochautomatischen Vorgang, wenn der Chip vollständig von der adhäsiven Trägerfolie abgelöst ist und keine Restadhäsionskräfte auf den Chip wirken, die den Chip beim Aufnehmen belasten könnten. Durch das Durchschneiden der Trägerfolie während des Abhebevorgangs mit der erfindungsgemäßen Ausstoßvorrichtung wird dies gewährleistet.

Im Weiteren werden anhand der Figuren 1 bis 7 die weiteren Vorteile und Merkmale der vorliegenden Erfindung beschrieben.
Figur 1: zeigt eine Ausstoßvorrichtung nach dem Stand der Technik
Figur 2: zeigt eine erfindungsgemäße Ausstoßvorrichtung während des Abhebevorgangs eines Chips aus einem Chipverbund
Figur 3: zeigt eine erfindungsgemäße Nadel mit entsprechendem Schliff am vorderen Teil der Nadel
Figur 4a und 4b: zeigen eine spezielle Ausführungsform der Ausstoßvorrichtung mit Nadeln, Nadelhalter, Druckfeder und Nadelkopf aus zwei unterschiedlichen Perspektiven
Figur 5: zeigt schematisch eine Ausführungsform der Montagevorrichtung
Figur 6: zeigt eine Ausstoßvorrichtung, bei der die Nadeln ausgefahren sind
Figur 7: zeigt eine Nadel mit Dreiecksschliff am vorderen Teil der Nadel

Figur 1 zeigt wie nach dem Stand der Technik das Abheben eines Chips von einem Trägermaterial erfolgt. Ein Trägermaterial 1, z.B. eine adhäsive Trägerfolie, beispielsweise eine selbstklebende Trägerfolie, z.B. 0,9 mm dick, ist mit einer Anzahl Chips 2 versehen. Das Trägermaterial mit dem Wafer bzw. Chipverbund fährt im Betrieb über die Ausstoßvorrichtung und dabei wird der auszustoßende Chip in Position über der Ausstoßvorrichtung gebracht. Die Ausstoßvorrichtung hebt die Chips mit Nadeln von der Rückseite der Trägerfolie her ab. Die Nadeln nach dem Stand der Technik haben einen Durchmesser von 0,5 bis 0,7 mm. Durch das Abheben der Chips von der Rückseite, also der der Trägerfolie zugewandten Seite her, löst sich die adhäsive Trägerfolie am Rand von den Chips, wobei hier nach dem Stand der Technik Nadeln mit stark abgerundeter Spitze und Kegelform verwendet werden, so dass beim Abhebevorgang das Trägermaterial von den Nadeln nicht durchstochen oder durchtrennt wird. Dadurch wird das Trägermaterial unter dem Druck der Nadeln mitangehoben und in eine im allgemeinen parabolische Form deformiert. Die Ablösung des Trägermaterials vom Chip erfolgt nur am Rand des Chips, wo das Trägermaterial unten gehalten wird, da es in einer Rahmenanordnung befestigt ist und außerdem über Vakuum angesaugt wird. Wird die Folie hier dennoch durchstochen, so entsteht ein kleines Loch. Beim Hochfahren der Nadeln wird die Trägerfolie mitangehoben, bedingt durch die konische Form der Nadeln. Nun liegt der Chip bereit zum Abnehmen durch einen Vakuumgreifer z. B. von der dem Trägermaterial gegenüber liegenden Seite des Chips her. Dabei wirkt nach dem Stand der Technik über die am Chip verbleibende Adhäsionsfläche des Trägermaterials eine Resthaftung am Chip, so dass hier beim Abnehmen durch den Vakuumgreifer die Gefahr besteht, dass der Chip bricht. Eine weiterer Nachteil ist hier, wie in Figur 1 zu sehen ist, dass durch das Mitanheben der Trägerfolie die benachbarten Chips ebenfalls mit angehoben werden und dabei gekippt werden und dadurch die Gefahr besteht, dass ihre Kanten mit den wiederum benachbarten Chips aufeinander rutschen und dabei beschädigt werden.

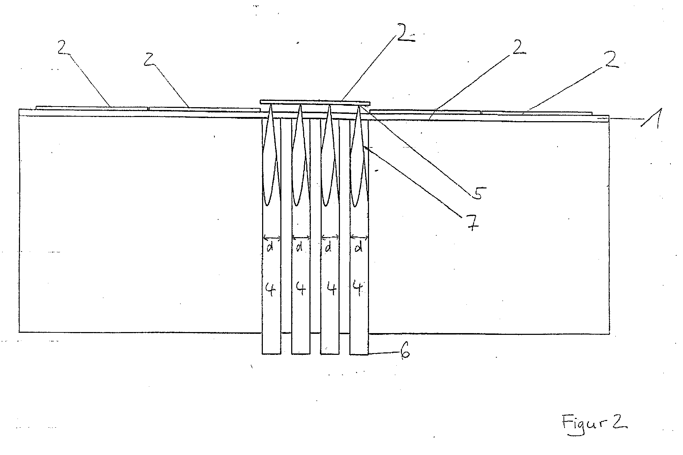

Dieses Verfahren nach dem Stand der Technik ist insbesondere bei Halbleiterwafern problematisch, die während des Herstellungsprozesses stark gedünnt werden und eine Waferdicke von z.B. nur 20 bis 100 µm aufweisen. Solche dünnen Wafer entstehen insbesondere bei der Prozessierung von MMICs (monolithische Mikrowellen- oder Millimeterwellen-integrierte Schaltungen). Diese gedünnten Wafer werden zur Vereinzelung der Chips auf einem Trägermaterial aufgebracht. Dieses Trägermaterial kann eine adhäsive Trägerfolie sein. Die Folie wird über einen Rahmen gespannt und die zu vereinzelnden Chips werden auf der Trägerfolie gesägt, ohne dass die Trägerfolie mit durchgesägt wird. Das Sägen erfolgt mechanisch oder mit einem Laserstrahl. Die ausgesägten Chips sind durch einen schmalen Sägegraben mit einer Breite zwischen 5 µm und 30 µm voneinander getrennt und liegen voneinander separiert auf der Trägerfolie. Insbesondere für MMICs, aus III/V-Halbleitermaterial gefertigte Chips, also z.B. aus GaAs oder InP gefertigte Chips, die auf 20 bis 100 µm gedünnt sind, ist das Verfahren des Standes der Technik mit einer hohen Beschädigungsrate verbunden. Um hier die Ausbeute an funktionierenden Chips zu erhöhen, ist das erfindungsgemäße Verfahren, das in Figur 2 schematisch dargestellt ist, vorteilhaft.

In Figur 2 liegen die abzuhebenden Chips 2 auf einem Trägermaterial 1, z. B. einer adhäsiven Trägerfolie, und der Chip 2 wird in diesem Beispiel mit 8 Nadeln angehoben (4 Nadeln sind verdeckt), die den Chip 2 von der Trägerfolie und dem Chipverbund abheben. Nach dem erfindungsgemäßen Verfahren ist die Ausstoßvorrichtung derartig gefertigt, dass beim Abheben des Chips mittels der Ausstoßvorrichtung das Trägermaterial von der mindestens einen Nadel beim Abheben durchschnitten wird. Im Beispiel der Figur 2 sind es 8 Nadeln, die jeweils mit mindestens einer Schneide 7 präpariert sind. Die Nadelspitze bewirkt, dass die Trägerfolie leicht durchstochen wird, und die Schneide bewirkt, dass beim Druck der durch das Anheben bzw. Hochfahren der Nadeln an der Trägerfolie erzeugt wird, die Schneide das Trägermaterial entlang des Anhebeweges durchschneidet.

Unter Nadel wird eine stabförmige Vorrichtung gesehen. Der vordere Teil der Nadel ist der Teil, der am Abhebevorgang beteiligt ist. Dabei ist die Nadelspitze das vorderste Ende der Nadel, über die der Druck auf den Chip übertragen wird und auf dem der Chip beim Abheben aufliegt. Daran anschließend ist der vordere Teil der Nadel.

Die erfindungsgemäßen Nadeln können aus einem Nadelrohling, beispielsweise einem Drahtstift, hergestellt werden. Dabei können beliebige Querschnittsformen des Drahtstifts verwendet werden, also z.B. runde, eckige oder flache Querschnittsformen. Damit die Nadel möglichst mühelos die Trägerfolie durchschneidet, wurde erfindungsgemäß erkannt, den vorderen Teil der Nadel derart zu präparieren, dass die Nadel in dem Teil, der die ursprüngliche Ebene der Trägerfolie beim Abheben überragt, mit mindestens einer Schneidkante präpariert ist. Dazu wird der vordere Teil der Nadel mit mindestens einer Kante versehen, die als Schneide für das Trägermaterial dient und geschärft ist und eine möglichst glatte polierte Oberfläche aufweist. Dies bewirkt, dass der Eindringwiderstand der Nadel aufgrund der keilförmigen Schneide gegenüber dem Trägermaterial gering ist und das Trägermaterial von der Nadel während des Abhebevorgangs durch die mindestens eine Schneidkante durchschnitten wird. Bevorzugt kann zusätzlich die Nadel so präpariert sein, dass sie sich zur Nadelspitze hin verjüngt, also dünner wird.

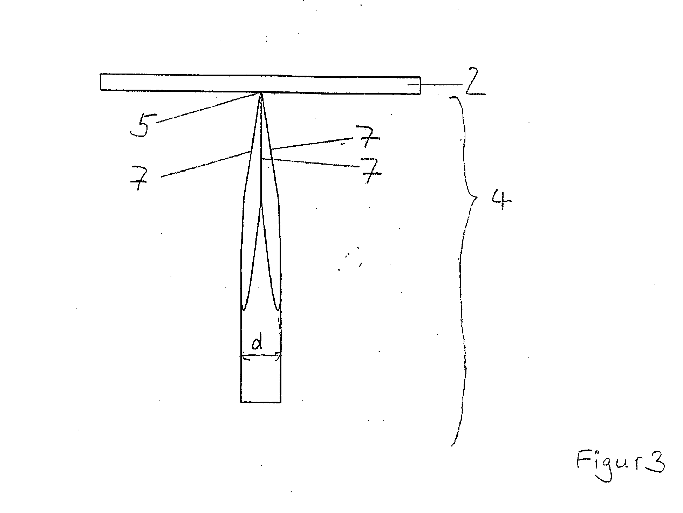

Eine besonders bevorzugte Ausführungsform einer erfindungsgemäßen Nadel ist in Figur 3 dargestellt. Diese Nadel 4 hat einen dreieckförmigen Anschliff, so dass drei Schneiden 7 entstehen, die das Trägermaterial 1 während des Abhebevorgangs durchschneiden.

Insbesondere kann der vordere Teil der Nadel zur Nadelspitze hin dünner werdend präpariert werden, wobei außerdem drei Seitenkanten entlang zumindest eines Abschnitts des vorderen Teils der Nadel präpariert werden. Der Anschliff mit den drei Schneiden ergibt einen in dreieckförmigen Querschnitt der Nadel im vorderen Teil.

Es wird also eine Nadel zum Abheben eines Chips von einem Trägermaterial verwendet, die mit drei Schneiden versehen ist.

Erfindungsgemäß wurde erkannt, dass der Eindringwiderstand der Nadel in das Trägermaterial ebenfalls stark verringert ist, wenn die Nadel aus einem Drahtstift gefertigt wird, dessen Durchmesser kleiner oder gleich 0,25 mm ist. Übliche im Stand der Technik verwendete Nadeln haben einen Durchmesser von 0,5 bis 0,7 mm. Eine solche Nadeldicke setzt der Trägerfolie eine zu große Fläche entgegen, so dass das Trägermaterial mit solchen Nadeln üblicherweise nicht durchstochen wird. Selbst wenn die Spitze ausgehend von diesem Nadeldurchmesser mit einem Schliff versehen wird, der zur Nadelspitze hin spitz zuläuft, setzt eine derartige Nadel zu viel Widerstand entgegen, so dass beim weiteren Hochfahren der Nadel die Trägerfolie mitgezogen und mitangehoben wird. Dahingehend wird erfindungsgemäß die Ausstoßvorrichtung mit einer Nadel betrieben, die einen entsprechend kleinen Durchmesser aufweist, so dass die Nadel das Trägermaterial durchdringen kann. In Verbindung mit einem Schliff am vorderen Teil der Nadel hin zur Nadelspitze, der insbesondere mindestens eine Schneide aufweist, wurde hier erkannt, dass dabei die Trägerfolie beim Abheben der Chips kaum mit angehoben wird. Ausgehend von Nadeldurchmessern von 0,25 mm kann die Nadelspitze entsprechend fein gearbeitet werden.

Je nach Form des abzuhebenden Chips bzw. je nach Größe seiner Chipfläche wird eine Ausstoßvorrichtung mit mehreren Nadeln benötigt. Daher ist die Ausstoßvorrichtung in Abhängigkeit der Chipfläche des abzuhebenden Chips mit Nadeln bestückbar. Der Chip liegt dann nach dem Anheben wie auf einem Nadelkissen, wie Figur 2 ebenfalls zeigt. Dies führt dazu, dass der Chip nicht mehr bricht. Bei einer Chipfläche von 1 mm² werden erfindungsgemäß vier Nadeln in die Ausstoßvorrichtung eingesetzt. Durch die Wahl eines geringen Durchmessers der verwendeten Nadeln kann die Nadeldichte heraufgesetzt werden. Z.B. wurde ein Chip der Fläche 1 x 1,5 mm² mit fünf Nadeln gleichzeitig abgehoben. Durch die Verwendung mehrerer Nadeln zum Abheben eines Chips wird das Biegemoment, das auf den Chip durch den Druck beim Abheben wirkt, verringert. Damit wird die Chipbruchgefahr verringert. Auch sehr große Chips können mit einer erfindungsgemäßen Ausstoßvorrichtung abgehoben werden. Als weiteres Beispiel wurde ein 4 x 1 mm² großer Chip mit 12 Nadeln abgehoben. Dies zeigt, dass erfindungsgemäß mit Nadeldichten gearbeitet wird, bei denen eine Nadel auf 0,33 mm² Chipfläche ansetzt.

Bevorzugt wird erfindungsgemäß mit einer Nadeldichte gearbeitet, die mindestens 1 Nadel auf 0,25 mm² beträgt.

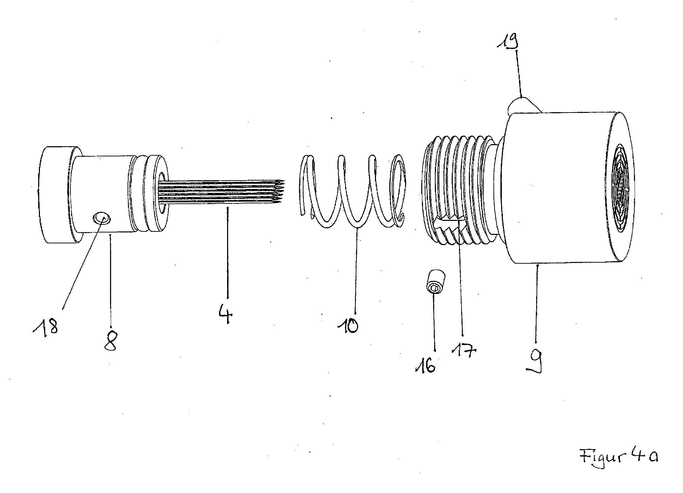

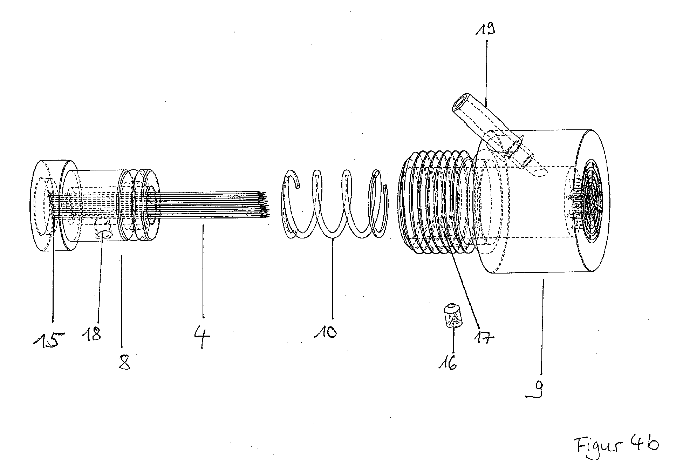

Figuren 4a und 4b zeigen eine spezielle Ausführungsform der Ausstoßvorrichtung. Die Ausstoßvorrichtung setzt sich dabei zusammen aus einem Nadelhalter 8, in dem die Nadeln 4 fixiert werden können. Der Nadelhalter 8 der Ausstoßvorrichtung ist hier mit 12 Nadeln präpariert. Die Nadeln 4 sind in Bohrungen 15 des Nadelhalters aufgenommen. In Figur 4a und 4b ist die Ausstoßvorrichtung demontiert gezeigt. Beim zusammengesetzten Ausstoßwerkzeug wird der Nadelhalter 8 über eine Druckfeder 10 in den Nadelkopf 9 gesteckt und so verbunden. Die Madenschraube 16 dient zur Verbindung des Schraublochs 18 im Nadelhalter mit dem Langloch 17 des Nadelkopfes 9. Die Druckfeder 10 bewirkt, dass der Nadelkopf 9 und der Nadelhalter 8 zusammengedrückt werden können. Das heißt, Nadelkopf 9 und Nadelhalter 8 können im zusammengefügten Zustand relativ zueinander bewegt werden. Dies hat den Vorteil, dass sich die Nadelspitzen 5 im Ruhezustand innerhalb des Nadelkopfes 9 befinden. Die Nadelspitzen sind ca. 0,5 mm versenkt unter der Oberfläche des Ausstoßwerkzeuges, also hier des Nadelkopfes 9, montiert. Im Betrieb fährt die Trägerfolie 1 mit dem Wafer über den Nadelkopf 9 und kann so die Nadelspitzen 7 nicht beschädigen. Wenn sich der entsprechende Chip 2 in der richtigen Position befindet, werden die Nadelspitzen 7 nach oben aus dem Nadelkopf 9 gedrückt und wirken auf den darüber liegenden Chip 2 ein.

In den Figuren 4a und 4b ist außerdem ein Vakuumansaugstutzen 19 zu sehen, über den im Betrieb der Ausstoßvorrichtung ein Schlauch zum Anlegen von Vakuum an die Vakuumbohrungen 20 geschoben wird. Das Vakuum dient im Betrieb der Ausstoßvorrichtung dazu, dass das Trägermaterial über die Vakuumbohrungen mittels Vakuum festgehalten wird und so den Abhebevorgang des Chips vom Trägermaterial unterstützt. Das Trägermaterial wird durch das Vakuum angesaugt und gehalten.

Dabei ist in einer Ausführungsform Gegenstand der Erfindung, die Nadeln im Nadelhalter derart zu fixieren, dass sie während des Fixiervorganges nicht verzogen werden. Insbesondere wenn die Ausstoßvorrichtung mit mehr als einer Nadel bestückt wird, ist es wichtig, dass die Nadelspitzen auf einer Ebene ausgerichtet sind. So werden die mechanischen Kräfte, die auf den Chip durch den Druck der Nadeln einwirken, optimal verteilt. Daher wird die Ausstoßvorrichtung bevorzugt mit in einem erstarrten Medium fixierten Nadeln betrieben. Dagegen wird im Stand der Technik bei der Fixierung der Nadeln im Ausstoßwerkzeug einseitig mechanische Kraft aufgewendet. Die Nadeln im Stand der Technik werden in ihrer Haltebohrung durch Madenschrauben fixiert. Durch das Festziehen der Madenschrauben können sich die Nadeln leicht verschieben oder in der Bohrung verspannen und damit ist eine einheitliche Ausrichtung der Nadelspitzen nicht mehr gewährleistet.

Die vorliegende Erfindung hat nun erkannt, dass eine Fixierung der Nadeln über ein Medium vorteilhaft ist, das im erstarrten Zustand die Nadeln in der Ausstoßvorrichtung fixiert. Insbesondere eignet sich hierzu ein Schmelzklebstoff, der vom flüssigen in den festen Zustand übergeht, wenn die Temperatur verändert wird. Die Nadeln werden in die Bohrungen des Nadelhalters geführt, wobei an den Nadelenden im Nadelhalter das Medium aufgebracht wird, entweder im flüssigen Zustand aufgebracht wird oder nach Aufbringen verflüssigt wird. Das anschließende Erstarren verbindet die Nadeln über das Medium mit dem Nadelhalter. Damit sind die Nadeln fest im Nadelhalter fixiert. Nach dem Einsatz der Ausstoßvorrichtung können die Nadeln über ein geeignetes Lösungsmittel wieder entfernt werden. Daher ist ein Schmelzklebstoff besonders geeignet, da er über ein Lösungsmittelbad vollständig entfernt werden kann. Dazu wird der Nadelhalter mit den Nadeln in ein Lösungsmittelbad gelegt. Als Lösungsmittel eignet sich z.B. Aceton. Dadurch wird das der Schmelzklebstoff aufgelöst und die Nadeln können aus den Bohrungen entfernt werden und die Ausstoßvorrichtung erneut präpariert werden. Ein so geeigneter Schmelzklebstoff ist Crystalbond 509^{™}.

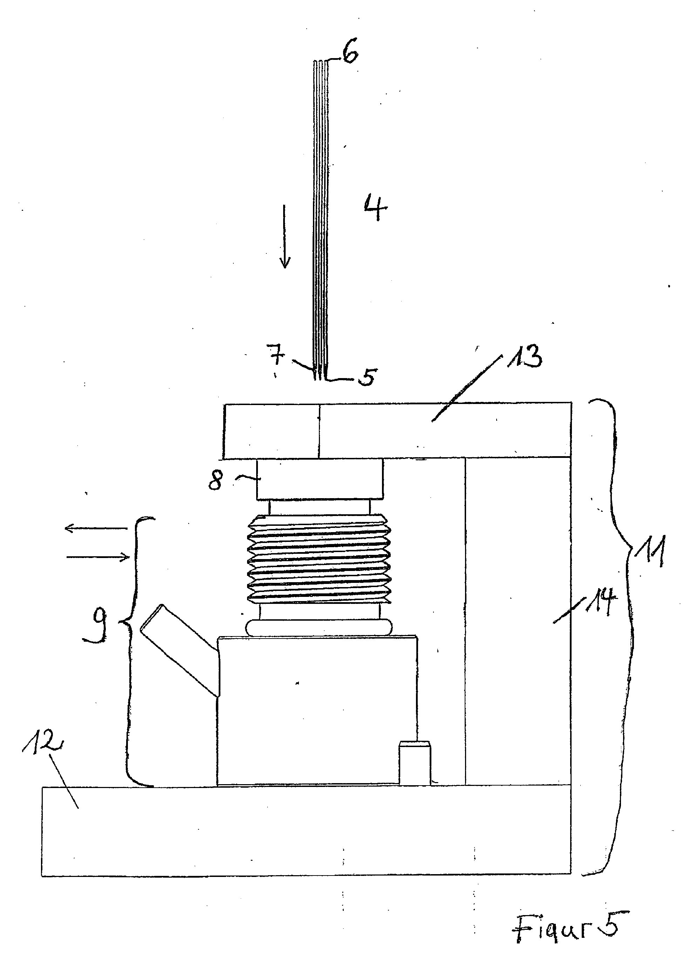

Figur 5 zeigt schematisch eine Montagevorrichtung 11, die zum Einbringen und Fixieren der Nadeln 4 in die Ausstoßvorrichtung verwendet wird. Die Montagevorrichtung 11 besteht aus einer ebenen Platte 12, auf der die Nadelspitzen 5 während der Montage aufliegen, und aus einer abnehmbaren Vorrichtung 13, die so an der Ausstoßvorrichtung zur Montage angebracht wird, dass eine in der abnehmbaren Vorrichtung 13 befindliche Ausnehmung über dem Nadelhalter 8 angebracht ist. Die abnehmbare Vorrichtung 13 wird über das Verbindungsstück 14 mit der ebenen Platte 12 verbunden. Der Nadelhalter wird dabei durch die abnehmbare Vorrichtung ca. 0,5 mm tief auf die Druckfeder gedrückt.

Dabei kann der Nadelhalter 8 entweder bereits beim Einbringen der Ausstoßvorrichtung in die Montagevorrichtung , - also noch vor dem Einbringen der Nadeln 4 in die Bohrungen des Nadelhalters 8 -, durch die abnehmbare Vorrichtung 13 auf die Druckfeder 10 gedrückt werden und so zur weiteren Montage gehalten werden,
oder die Montagevorrichtung wird so verwendet, dass die Ausstoßvorrichtung zuerst so in der Montagevorrichtung montiert wird, dass der Nadelhalter noch nicht auf die Druckfeder gedrückt gehalten wird. Erst wenn die Nadeln 4 bereits in die Bohrungen 15 eingeführt sind und erst nach Aufbringen des Klebstoffs auf die Nadelenden im Nadelhalter 8 wird die abnehmbare Vorrichtung 13 mittels einer Schraube oder eines Exzenters nach unten bewegt, drückt dabei den Nadelhalter 8 auf die Druckfeder 10 der Ausstoßvorrichtung, und nimmt dabei durch den Klebstoff eventuell nach oben gezogene Nadeln 4 wieder mit nach unten. So wird noch besser gewährleistet, dass alle Nadelspitzen 5 auf der ebenen Platte 12 aufliegen, wenn der Klebstoff erstarrt.

Zur Montage der Nadeln werden die Nadeln 4 in die Bohrungen der Ausstoßvorrichtung eingebracht. Dabei wird bevorzugt jeweils eine Nadel in jeweils eine Bohrung der Ausstoßvorrichtung eingebracht. Die Nadeln liegen lose in den Bohrungen der Ausstoßvorrichtung und liegen mit ihren Nadelspitzen auf der ebenen Platte 12 durch ihr Eigengewicht auf. Die Platte 12 dient zur Ausrichtung der Nadelspitzenebene. Daher weist die Platte 12 eine geschliffene, sehr ebene Fläche auf. Der Fehlerunterschied der Nadelspitzenebene wird durch die erfindungsgemäße Montagevorrichtung auf wenige µm reduziert. Nun werden die Nadeln in der Ausstoßvorrichtung fixiert. Bevorzugt wird dabei ein Schmelzklebstoff auf die Nadelenden im Nadelhalter aufgebracht, der Schmelzklebstoff aufgeschmolzen und anschließend erstarrt. Zum Verflüssigen des Schmelzklebstoffs wird die Montagevorrichtung 11 zusammen mit der Ausstoßvorrichtung auf eine Heizplatte gelegt und durch eine Heizplatte auf ca. 120 ° C erwärmt. Dazu besteht die Montagevorrichtung aus einem gut wärmeleitfähigem Material, also z. B. eine metallische Platte, metallisches Verbindungsstück und metallische abnehmbare Vorrichtung. Besonders geeignet ist hier Werkzeugstahl, der außerdem sehr gut zu einer ebenen Platte 12 geschliffen werden kann, insbesondere gehärteter Werkzeugstahl. Der Schmelzklebstoff wird über die Ausnehmung, die eine Öffnung in der abnehmbaren Vorrichtung 13 ist, auf den Nadelhalter 8 und den sich darin befindlichen Nadelenden 6 aufgebracht, erwärmt sich und verbindet die Nadelenden 6 mit dem Nadelhalter 8 und fixiert diese fest beim anschließenden Erstarren. Damit ist gewährleistet, dass die Nadeln fest am Werkzeug fixiert werden und dennoch durch die Fixierung nicht dejustiert werden. Insbesondere eignet sich hier ein Schmelzklebstoff, der vorteilhaft als Granulat aufgebracht wird und dann aufgeschmolzen wird. Die Montagevorrichtung ist außerdem bevorzugt so aufgebaut, dass die abnehmbare Vorrichtung so montiert und festgeschraubt wird, dass der Nadelhalter dabei ca. 0,5 mm tief auf die Feder gedrückt wird. Die Nadeln werden dann fixiert. Nach dem Entnehmen der Ausstoßvorrichtung nach dem Fixiervorgang aus der Montagevorrichtung befinden sich die Nadeln um ca. 0,5 mm versenkt in der Ausstoßvorrichtung.

Das Einbringen der Nadeln in die Ausstoßvorrichtung kann auch optional unter einem Mikroskop durchgeführt werden. Dazu befindet sich die Ausstoßvorrichtung im zusammengesetzten Zustand aus Nadelhalter, Druckfeder und Nadelkopf. Der Nadelkopf liegt auf einer Vormontagehilfe aus Kunststoff auf, damit die Nadeln bei Einbringen in die Bohrungen mit ihrer Spitze auf einem weichen Kunststoff zu liegen kommen. Dies gewährleistet, dass die Nadelspitzen beim Auftreffen nicht verletzt werden. Mit Hilfe dieser Vormontagehilfe aus Kunststoff kann das Ausstoßwerkzeug nun kopfüber auf die Montagevorrichtung gelegt werden. Dann wird die Vormontagehilfe entfernt. Nun wird die abnehmbare Vorrichtung wie beschrieben auf der Ausstoßvorrichtung montiert und festgeschraubt.

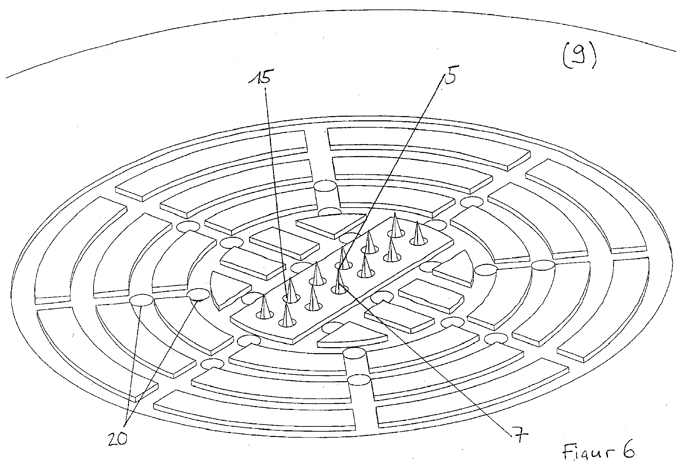

Figur 6 zeigt eine mit Nadeln 4 präparierte Ausstoßvorrichtung, wobei hier der Nadelkopf 9 von oben zu sehen ist, und die Nadeln 4 dabei herausgedrückt werden. Auf der Zeichnung sind die Bohrungen 15 für die Nadeln im Nadelkopf 9 zu sehen. Bei Verwendung von Nadeln mit einem Durchmesser von 0,25 mm sind die Bohrungen 15 in etwa 0,27 mm im Durchmesser.

Durch die Vakuumbohrungen 20 strömt beim Abhebevorgang des Chips vom Trägermaterial Vakuum an das Trägermaterial und das Trägermaterial wird dadurch am Nadelkopf gehalten.

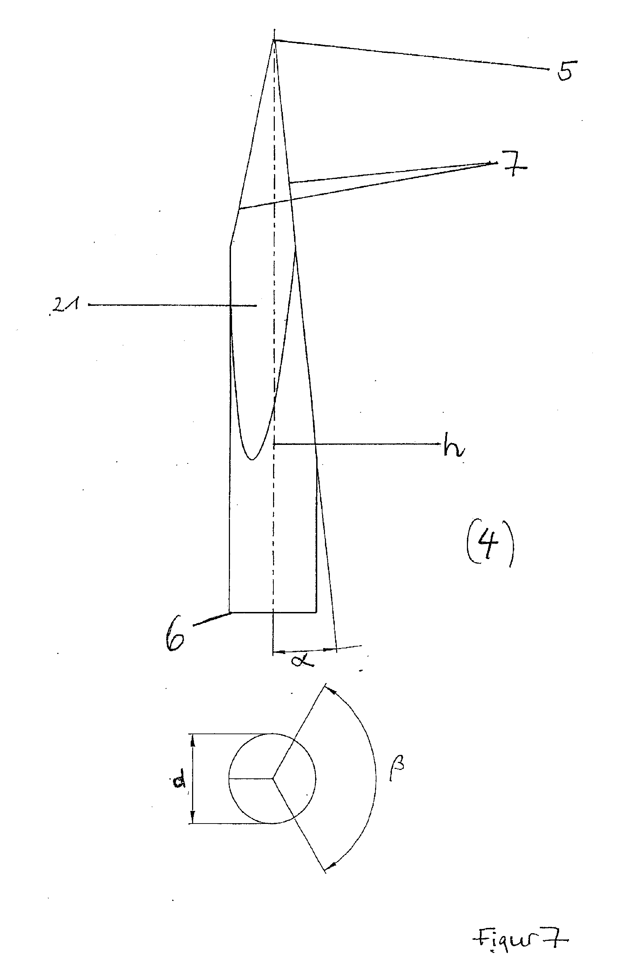

Figur 7 zeigt die Anfertigung einer erfindungsgemäßen Nadel, die im vorderen Teil der Nadel mit drei Schneiden (eine verdeckt), die als spitze, keilförmige Seitenkanten herausgearbeitet sind, versehen ist, und zur Spitze der Nadel hin sich verjüngt, so dass die Spitze entsprechend spitz herausgearbeitet ist. Damit wird beim Abheben der Nadel, wenn die Nadel gegen das Trägermaterial und den darauf liegenden Chip gedrückt wird, das Trägermaterial zuerst durchstochen und dann, durch den weiteren Druck der Nadel und damit den hohen Druckkräften der Schneidkante gegen das Trägermaterial dieses von der Schneide durchschnitten beim Hochfahren der Nadel bis zu dem Punkt, wo der Chip zum Aufnehmen durch das Aufnahmewerkzeug präsentiert wird. Der Druck gegen das Trägermaterial bzw. gegen die Trägerfolie durch das Drücken der Nadel gegen das Trägermaterial und gegen den Chip wird also durch das Durchschneiden von der Trägerfolie genommen, so dass diese sich nicht verbiegt oder weiter angehoben wird, und damit auch kaum Druck auf den Chip selbst und kein Verrutschen der benachbarten Chips zu Chipbeschädigungen führt. Außerdem wird die Trägerfolie vollständig vom Chip gelöst, so dass beim Aufnehmen des Chips durch das Aufnahmewerkzeug keine Restadhäsionskräfte den Chip festhalten.

Die Seitenkanten 7 sind auf der Zeichnung als geradlinige Seitenkanten gezeichnet. Diese können aber auch bogenförmig nach außen oder auch nach innen gekrümmt geschliffen werden. Die Seitenfläche 21 zwischen zwei Schneidkanten kann als gerade Fläche zwischen den beiden Schneidkanten gearbeitet sein. Die Seitenfläche 21 kann jedoch auch gekrümmt zwischen den Seitenkanten geschliffen sein. Um die Schärfe der Seitenkanten zu erhöhen, kann die Seitenfläche insbesondere bogenförmig nach innen geschliffen sein.

Die Länge der hier verwendeten Nadeln beträgt 29 mm. Dies ist jedoch je nach Ausstoßvorrichtung und Fertigungsautomat anzupassen und ist typischerweise zwischen 10 mm und 30 mm. Der Stand der Technik arbeitet mit kegelförmigen Spitzen. Erfindungsgemäß werden nun geschärfte Seitenkanten entlang des vorderen Teils der Nadel geschliffen.

Die drei Schneiden werden aus einem Drahtrohling im Winkel β zueinander geschliffen. Dieser Winkel kann etwa 120 ° betragen, kann jedoch auch davon abweichen, so dass die drei Schneiden nicht im gleichen Winkelabstand voneinander liegen. Der bevorzugte Durchmesser, von dem ausgehend die Nadel geschliffen wird, ist kleiner oder gleich 0,25 mm. Der jeweilige Winkel α zwischen Höhe h und Seitenkante bzw. Schneide 7 kann beliebig gewählt werden. Die Höhe h ist das Lot, das von der Nadelspitze auf die Grundflächenebene gefällt wird, wobei die Grundflächenebene die Querschnittsfläche am Nadelende 6 ist. Ein bevorzugt gewählter Winkel α beträgt hier 4° bis 8°.

### Bezugszeichenliste

(1) Trägermaterial
(2) Chip
(4) Nadel
(5) Nadelspitze
(6) Nadelende
(7) Schneide
(8) Nadelhalter
(9) Nadelkopf
(10) Druckfeder
(11) Montagevorrichtung
(12) ebene Platte
(13) abnehmbare Vorrichtung
(14) Verbindungsstück zwischen (12) und (13)
(15) Bohrung für Nadel
(16) Schraube
(17) Langloch
(18) Schraubloch
(19) Vakuumansaugstutzen
(20) Vakuumbohrungen
(21) Seitenfläche
(d) Durchmesser
(h) Höhe
(α) Winkel α
(β) Winkel β

## Patentansprüche

1. Ausstoßvorrichtung zum Abheben eines Chips (2) von einem Trägermaterial (1)
mit mindestens einer Nadel (4),
**dadurch gekennzeichnet, dass** die Nadel (4) mindestens eine Schneide (7) aufweist
zum Durchschneiden des Trägermaterials (1).

2. Ausstoßvorrichtung zum Abheben eines Chips (2) von einem Trägermaterial (1) nach Anspruch 1,
**dadurch gekennzeichnet, dass** die Schneide (7) als Seitenkante entlang des vorderen Teils der Nadel (4) ausgebildet ist.

3. Ausstoßvorrichtung zum Abheben eines Chips (2) von einem Trägermaterial (1)
nach Anspruch 1 oder 2, mit mindestens einer Nadel (4), **dadurch gekennzeichnet, dass** der Durchmesser (d) der Nadel (4) kleiner oder gleich 0,25 mm ist.

4. Ausstoßvorrichtung nach einem der Ansprüche 1, 2 oder 3, **dadurch gekennzeichnet, dass** die Nadel (4) drei Schneiden (7) aufweist zum Durchschneiden des Trägermaterials (1).

5. Ausstoßvorrichtung nach Anspruch 4,
**dadurch gekennzeichnet, dass** die Schneiden (7) als drei scharfe Seitenkanten entlang des vorderen Teils der Nadel (4) führen.

6. Ausstoßvorrichtung nach einem der Ansprüche 1 bis 5, **dadurch gekennzeichnet, dass** die Ausstoßvorrichtung einen Nadelhalter (8) aufweist mit Bohrungen zum Aufnehmen mindestens einer Nadel (4), die Ausstoßvorrichtung desweiteren einen Nadelkopf (9) aufweist und eine Druckfeder (10), wobei der Nadelkopf (9) und der Nadelhalter (8) derart zusammenfügbar sind, dass über die Druckfeder (10) Nadelkopf (9) und Nadelhalter (8)im zusammengefügten Zustand relativ zueinander bewegbar sind.

7. Ausstoßvorrichtung nach einem der Ansprüche 1 bis 6, **dadurch gekennzeichnet, dass** die Ausstoßvorrichtung in Abhängigkeit der Chipfläche des abzuhebenden Chips (2) mit Nadeln (4) bestückbar ist, wobei die Nadeldichte mindestens drei Nadeln pro 1 mm² Chipfläche beträgt.

8. Ausstoßvorrichtung nach Anspruch 6 oder 7, **dadurch gekennzeichnet, dass** die mindestens eine Nadel (4) mittels Schmelzklebstoff im Nadelhalter (8) fixiert ist.

9. Verfahren zum Fixieren von mindestens einer Nadel in einem Nadelhalter (8) einer Ausstoßvorrichtung zum Abheben eines Chips von einem Trägermaterial, wobei die Nadeln eine Nadelspitze und gegenüberliegend ein Nadelende aufweisen,
mit den Schritten
- Einbringen der mindestens einen Nadel in einen Nadelhalter der Ausstoßvorrichtung,
- Fixieren der Nadeln, wobei die Nadelenden der Nadeln im Nadelhalter mittels eines Klebstoffs durch Erstarren oder Aushärten des Klebstoffs im Nadelhalter fixiert werden,
**dadurch gekennzeichnet, dass** der Klebstoff ein Schmelzklebstoff ist und in Form eines Granulats an die Nadelenden gebracht wird, in einem weiteren Schritt aufgeschmolzen wird und in einem weiteren Schritt erstarrt wird.

10. Verfahren nach Anspruch 9, **dadurch gekennzeichnet, dass** vor dem Fixieren der Nadeln folgende Schritte erfolgen:
- Einbringen der mindestens einen Nadel in mindestens eine Bohrung des Nadelhalters, wobei jeweils eine Nadel in jeweils eine Bohrung des Nadelhalters eingebracht wird
- Ausrichten der Nadelspitzenebene, wobei die lose in den Bohrungen der Ausstoßvorrichtung geführten Nadeln mit ihren Nadelspitzen auf einer ebenen Platte durch ihr Eigengewicht ausgerichtet werden.

11. Verfahren nach Anspruch 9 oder 10,
**dadurch gekennzeichnet, dass** nach dem Aufbringen des Schmelzklebstoff-Granulats und Aufschmelzen des Schmelzklebstoff-Granulats noch vor dem Erstarren des Schmelzklebstoffs der Nadelhalter eine kuze Distanz nach unten in Richtung der ebenen Platte bewegt wird,
um vor dem Erstarren des Schmelzklebstoffs ein Ausrichten der Nadelspitzen auf der ebenen Platte zu überprüfen.

12. Montagevorrichtung (11) zum Einbringen und Fixieren mindestens einer Nadel (4), wobei die Nadeln eine Nadelspitze und gegenüberliegend ein Nadelende aufweisen, in eine Ausstoßvorrichtung zum Abheben eines Chips von einem Trägermaterial
mit
- einer Platte (12) zum Ausrichten der Nadelspitzenebene
- und einer abnehmbaren Vorrichtung (13),
- und einem Verbindungsstück 14,
wobei die Platte (12) über das Verbindungsstück (14) mit der abnehmbaren Vorrichtung (13) verbindbar ist,derart, dass die abnehmbare Vorrichtung (13) so an Nadelhalter (8), Nadelkopf (9) und Druckfeder (10) der Ausstoßvorrichtung über das Verbindungsstück (14) anbringbar ist, dass die Nadeln (4) nach dem Fixierungsvorgang versenkt in der Ausstoßvorrichtung angebracht sind.

13. Montagevorrichtung nach Anspruch 12, **dadurch gekennzeichnet, dass** die abnehmbare Vorrichtung (13) eine Ausnehmung aufweist, und die abnehmbare Vorrichtung (13) derart über dem Nadelhalter der Ausstoßvorrichtung anbringbar ist, dass die Ausnehmung zum Einbringen des Fixiermaterials auf die Nadelenden im Nadelhalter dient.

14. Verfahren zum Abheben eines Chips (2) von einem Trägermaterial (1), mit den Schritten:
- Abheben des Chips (2) mittels mindestens einer Nadel (4),
- wobei das Abheben des Chips (2) von der dem Trägermaterial (1) zugewandten Seite des Chips (2) her erfolgt
- wobei das Abheben derart erfolgt, dass die mindestens eine Nadel (4) mindestens eine Schneide (7) aufweist und die mindestens eine Nadel (4) durch das Trägermaterial (1) hindurch den Chip (2) abhebt, und beim Abheben das Trägermaterial (1) durch die mindestens eine Schneide (7) durchschnitten wird.

15. Verfahren zum Abheben eines Chips (2) von einem Trägermaterial (1) nach Anspruch 14,
**dadurch gekennzeichnet, dass** die Schneide (7) als Seitenkante entlang des vorderen Teils der Nadel (4) ausgebildet ist.

16. Verfahren zum Abheben eines Chips (2) von einem Trägermaterial (1) nach Anspruch 14 oder 15,
**dadurch gekennzeichnet, dass** die mindestens eine Nadel (4) einen Durchmesser (d)kleiner oder gleich 0,25 mm aufweist.

17. Verfahren zum Abheben eines Chips (2) nach einem der Ansprüche 14, 15 oder 16, von einem Trägermaterial (1), **dadurch gekennzeichnet, dass**
- die Ausstoßvorrichtung in Abhängigkeit von der Fläche des abzuhebenden Chips (2) mit Nadeln (4) bestückt ist mit einer Nadeldichte von mindestens einer Nadel pro 0,33 mm² Chipfläche.

18. Fertigungsautomat zum Abheben eines Chips von einem Trägermaterial und Aufnehmen des Chips zur Weiterbearbeitung
mit einer Ausstoßvorrichtung nach einem der Ansprüche 1 bis 8 zum Abheben des Chips vom Trägermaterial und mit einem Aufnahmewerkzeug zum Aufnehmen des Chips von der Ausstoßvorrichtung.
